# EUROPEAN PATENT APPLICATION

(11) **EP 2 442 123 A2**
(43) Date of publication of application: **18.04.2012**
(21) Application number: 11008371.4
(22) Date of filing: 18.10.2011
(51) Int. Cl.: G01R 31/04

(54) **Acoustic apparatus and acoustic sensor apparatus including a clamp**

(30) Priority: 18.10.2010 US 906256
(71) Applicant: Eaton Corporation, Cleveland, OH 44114-2584 (US)
(72) Inventor: Zhou, Xin, Wexford, PA 15090 (US); Gass, Dale L., Brown Deer, WI 53223 (US); Pahl, Birger, Milwaukee, WI 53211 (US); Yanniello, Robert, Asheville, NC 28803 (US)
(74) Representative: Klang, Alexander H.

(57) **Abstract**

An acoustic sensor apparatus includes a housing; a clamp structured to clamp together the housing and an electrical power conductor; an acoustic sensor structured to detect acoustic noise from the electrical power conductor and output a signal; and a circuit structured to detect an electrical conductivity fault from the signal.

## Description

### CROSS-REFERENCE TO RELATED APPLICATIONS

This application is related to commonly assigned, copending United States Patent Application Serial No. 12/906,244, filed on October 18, 2010, entitled "ACOUSTIC SENSOR SYSTEM FOR DETECTING ELECTRICAL CONDUCTIVITY FAULTS IN AN ELECTRICAL DISTRIBUTION SYSTEM" (Attorney Docket No. 10-mPCS-244(PDA)); commonly assigned, copending United States Patent Application Serial No. 12/906,258, filed on October 18, 2010, entitled "ACOUSTIC SENSOR SYSTEM, ACOUSTIC SIGNATURE SIMULATOR, AND ELECTRICAL DISTRIBUTION SYSTEM" (Attorney Docket No. 10-mPCS-246(PDA)); and commonly assigned, copending United States Patent Application Serial No. 12/906,259, filed on October 18,2010, entitled "ACOUSTIC APPARATUS AND ACOUSTIC SENSOR APPARATUS INCLUDING A FASTENER" (Attorney Docket No. 10-mPCS-248(PDA)).

### BACKGROUND

### Field

The disclosed concept pertains generally to acoustic noise induced by electrical conductivity faults and, more particularly, to acoustic sensor systems. The disclosed concept also pertains to such acoustic sensor systems, which can also function as acoustic signature simulators for electrical distribution systems.

### Background Information

There is no known cost effective technology and product to detect loose electrical connections in electrical distribution systems. An infrared imaging scan has been widely used to find such loose electrical connections, but this does not provide continuous (e.g., "24-7" or 24 hours a day, seven days a week) detection and monitoring.

Other known products employ temperature sensing at each electrical joint. However, this has not been widely adopted due to cost.

It is believed to be almost impossible to extract a loose electrical connection signature from both current and voltage due to the relatively small voltage drop across a loose electrical connection (except when this escalates into a major arc fault or arc flash event) except by monitoring voltage drops at each electrical connection.

U.S. Patent No. 7,148,696 discloses that an acoustic signature is generated by an arc fault or a glowing contact. An acoustic sensor "listens" directly to signature noise generated by a fault, no matter what type of electrical load is present or in what kind of environment in which the fault is generated. The acoustic noise generated by an arc fault or a glowing contact has an acoustic signal at one or more specific wavelengths that is (are) directly related to either the basic characteristics of, for example, the arc and its resonance frequency or the AC power source modulated frequency and its harmonics. The acoustic signal of an arc fault is detected by an acoustic sensor. A resulting trip signal is sent to a trip mechanism to, for example, trip open separable contacts, in order to interrupt the arc fault.

U.S. Patent No. 7,411,403 discloses a circuit breaker that detects a loose electrical connection condition of a power circuit. The circuit breaker includes first and second lugs, and first and second acoustic couplers acoustically coupled to the power circuit. An acoustic generator is coupled to the second acoustic coupler and generates a first acoustic signal to the power circuit from the second acoustic coupler. An acoustic sensor is coupled to the first acoustic coupler and has a second acoustic signal which is operatively associated with the loose electrical connection condition. The acoustic sensor outputs a sensed acoustic signal. A circuit cooperates with the acoustic generator to generate the first acoustic signal, input the sensed acoustic signal, and detect the loose electrical connection condition therefrom. The circuit can output a trip signal to a trip mechanism upon detecting an electrical conductivity fault from the sensed acoustic signal.

There is a need for a cost effective technology and product to effectively detect loose electrical connections at their earliest stage in order to prevent potential equipment damage and/or personal injury.

There is room for improvement in acoustic apparatus and in acoustic sensor apparatus.

### SUMMARY

These needs and others are met by embodiments of the disclosed concept, in which an acoustic apparatus or acoustic sensor apparatus comprises a clamp structured to clamp together a housing and an electrical power conductor. This clamp permits, for example, the acoustic apparatus or acoustic sensor apparatus to be moved around relatively easily (e.g., not for permanent installation).

In accordance with one aspect of the disclosed concept, an acoustic sensor apparatus comprises: a housing; a clamp structured to clamp together the housing and an electrical power conductor; an acoustic sensor structured to detect acoustic noise from the electrical power conductor and output a signal; and a circuit structured to detect an electrical conductivity fault from the signal.

The electrical power conductor may be a rectangular bus bar; and the clamp may be structured to clamp together the housing and the rectangular bus bar.

The electrical power conductor may be a power cable having a circular or elliptical cross section; and the clamp may be structured to clamp together the housing and the power cable.

The housing may include an insulation spacer coupled to the acoustic sensor and being external to the housing; and the clamp may be further structured to clamp together the insulation spacer and the electrical power conductor.

The clamp may comprise a first clamp portion disposed within the housing and engaging the acoustic sensor, a second clamp portion disposed outside of the housing and being structured to engage the electrical power conductor, a threaded coupler passing through the first clamp portion and through the housing, the threaded coupler having a first end and an opposite second threaded end threadably coupled to the second clamp portion, and a rotatable member coupled to and structured to rotate along the first end of the threaded coupler in order to move up or down to pull or push the second clamp portion and clamp or unclamp, respectively, the housing, the electrical power conductor and the second clamp portion.

As another aspect of the disclosed concept, an acoustic apparatus is for an electrical power conductor. The acoustic apparatus comprises: a housing; a clamp structured to clamp together the housing and the electrical power conductor; and at least one of: (a) an acoustic sensor structured to detect acoustic noise from the electrical power conductor and output a signal, and a circuit structured to detect an electrical conductivity fault from the signal, and (b) an acoustic transmitter structured to generate acoustic noise to mimic acoustic noise induced by an electrical conductivity fault.

### BRIEF DESCRIPTION OF THE DRAWINGS

A full understanding of the disclosed concept can be gained from the following description of the preferred embodiments when read in conjunction with the accompanying drawings in which:
Figure 1 is a block diagram of an acoustic sensor in accordance with embodiments of the disclosed concept.
Figures 2A and 2B form a flowchart of a routine for the processor of Figure 1.
Figure 3 is a vertical elevation view of an acoustic sensor including a clamp-on structure for a rectangular power bus bar in accordance with another embodiment of the disclosed concept.
Figure 4 is an isometric view of the acoustic sensor of Figure 3.
Figure 5 is an isometric view of the acoustic sensor of Figure 3 except with the cover removed to show internal structures.
Figure 6 is a vertical elevation view of a clamp-on structure for a power conductor and an acoustic sensor in accordance with another embodiment of the disclosed concept.
Figure 7 is an isometric view of the clamp-on structure of Figure 6.

### DESCRIPTION OF THE PREFERRED EMBODIMENTS

As employed herein, the term "number" shall mean one or an integer greater than one (i. e., a plurality).

As employed herein, the term "acoustic" shall mean one or more sounds that are subsonic, sonic and/or ultrasonic.

As employed herein, the term "electrical power conductor" shall mean a wire (e.g., solid; stranded; insulated; non-insulated), a copper conductor, an aluminum conductor, a suitable metal conductor, an electrical bus bar, or other suitable material or object that permits an electric current to flow easily.

As employed herein, the term "electrical joint" shall mean a structure that electrically and mechanically connects a plurality of electrical conductors.

As employed herein, the term "lug" shall mean a terminal or other electrically conductive fitting to which one or more electrical conductors are electrically and mechanically connected.

As employed herein, the term "electrical conductivity fault" shall mean an arc fault, or a loose or other intermittent electrical connection of an electrical conductor, an electrical joint and/or a lug that leads to a glowing contact.

As employed herein, the statement that two or more parts are "connected" or "coupled" together shall mean that the parts are joined together either directly or joined through one or more intermediate parts. Further, as employed herein, the statement that two or more parts are "attached" shall mean that the parts are joined together directly.

As employed herein, the term "acoustic coupler" shall mean an acoustic lug; a clamp; or another suitable coupling mechanism to hold an electrical conductor and an acoustic sensor or an acoustic generator together to allow effective acoustic transmission with or without an electrical connection.

As employed herein, the term "signature" shall mean something that serves to set apart or identify another thing. For example, an acoustic signature serves to set apart or identify an electrical conductivity fault.

As employed herein, the term "fastener" shall mean rivets, adhesives, screws, bolts and the combinations of bolts and nuts (e.g., without limitation, lock nuts) and bolts, washers and nuts.

As employed herein, the term "bolt" shall mean a device or apparatus structured to bolt two or more parts together so as to hold them firmly, such as by bolting an electrical power conductor and a housing including an insulation spacer. A bolt can be, for example, a metal rod or pin for fastening objects together that usually has a head at one end and a screw thread at the other end and is secured by a nut.

As employed herein, the term "clamp" shall mean a device or apparatus structured to bind or constrict or to press two or more parts together so as to hold them firmly, such as by holding or compressing an electrical power conductor and an insulation spacer. The term "clamp" expressly excludes a fastener.

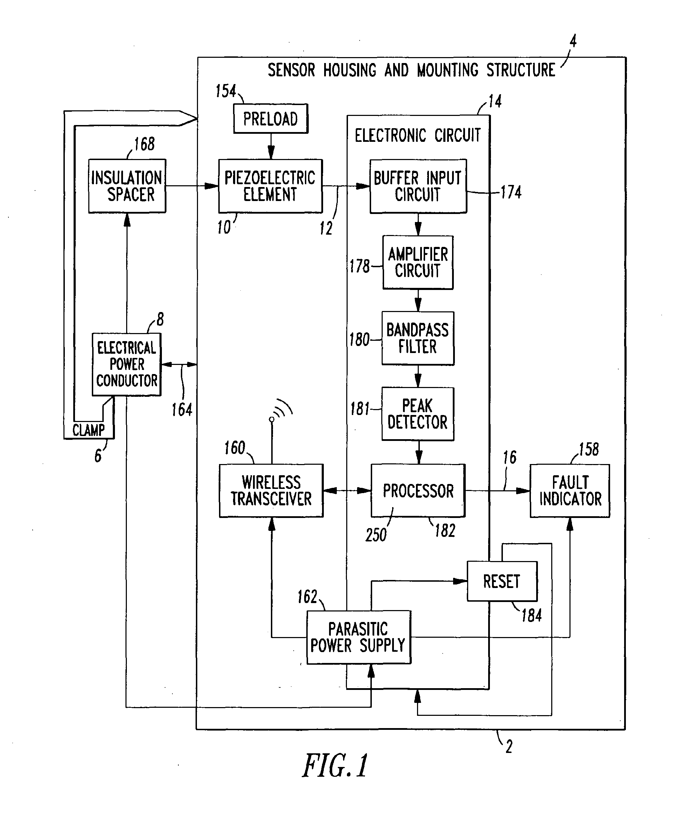

Referring to Figure 1, an acoustic sensor apparatus 2 includes a housing, such as an example sensor housing and mounting structure 4, a clamp 6 structured to clamp together the housing 4 and an electrical power conductor 8, an acoustic sensor, such as the example piezoelectric element 10, structured to detect acoustic noise from the electrical power conductor 8 and output a signal 12, and a circuit, such as an example electronic circuit 14, structured to detect an electrical conductivity fault 16 from the signal 12.

### Example 1

The example acoustic sensor apparatus 2 includes the example sensor housing and mounting structure 4, the clamp 6, the example piezoelectric element 10, an optional preload 154, the example electronic circuit 14 that outputs the electrical conductivity fault signal 16, a fault indicator 158, a communication device, such as a wireless transceiver 160, and a power supply 162.

The preload 154, which is not required, compresses the piezoelectric element 10 under pressure in its assembly. The "preload" means that the piezoelectric element 10 is compressed or under pressure in its assembly. The preload 154, which is applied to the example piezoelectric element 10, can be, for example and without limitation, a compression element such as a loaded compression spring. Alternatively, a clamp can be structured to provide the function of the preload.

The sensor housing and mounting structure 4 is suitably coupled, at 164, to an electrical power conductor 8 (e.g., without limitation, of switchgear (not shown); of an electrical distribution system (not shown)). The example piezoelectric element 10 is coupled to the electrical power conductor 8 by a suitable insulation spacer 168 or through the sensor housing by a suitable insulating spacer (not shown).

Although the power supply 162 is shown as being an example parasitic power supply (e.g., without limitation, employing a current transformer (CT) (not shown) that derives power from the energized electrical power conductor 8), it will be appreciated that a wide range of power supplies can be employed. The example parasitic power supply 162 includes a power harvesting capability such as by employing a number of power CTs (not shown) to harvest electrical power when there is current flowing through the electrical power conductor 8. Alternatively or in addition, power harvesting from the voltage of the electrical power conductor 8 can be employed.

The wireless transceiver 160 provides a suitable wireless communication capability (e.g., without limitation, IEEE 802.11; IEEE 802.15.4; another suitable wireless transceiver or transmitter) to communicate the detection of an electrical conductivity fault to another location (e.g., without limitation, a remote device, such as a control center (not shown); a control console (not shown); a trip unit (not shown); a protective relay (not shown), at a remote location) to alert maintenance personnel of the fault and its zone location.

The electronic circuit 14 includes a buffer input circuit 174 that receives the output signal 12 (e.g., an acoustic signal) from the piezoelectric element 10, an amplifier circuit 178, a bandpass filter 180, a peak detector 181 and a processor 182. A reset circuit 184 can reset the electronic circuit 14 after a power outage caused by the parasitic power supply 162 receiving insufficient power from the electrical power conductor 8.

The piezoelectric element 10 senses acoustic signals propagating through the electrical power conductor 8, and outputs the signal 12 to the buffer input circuit 174, which outputs a voltage signal to the amplifier circuit 178. The voltage signal is amplified by the amplifier circuit 178 that outputs a second signal. The second signal can be filtered by the bandpass filter 180 and input by the peak detector 181 that detects a peak signal and outputs that as a third signal. The third signal is analyzed by a routine 250 of the processor 182, in order to detect the electrical conductivity fault therefrom. This determines if an electrical conductivity fault, such as a glowing contact, exists. The piezoelectric element 10 can be preloaded with a predetermined pressure to maximize its output. The parasitic power supply 162 powers the electronics of the acoustic sensor apparatus 2.

### Example 2

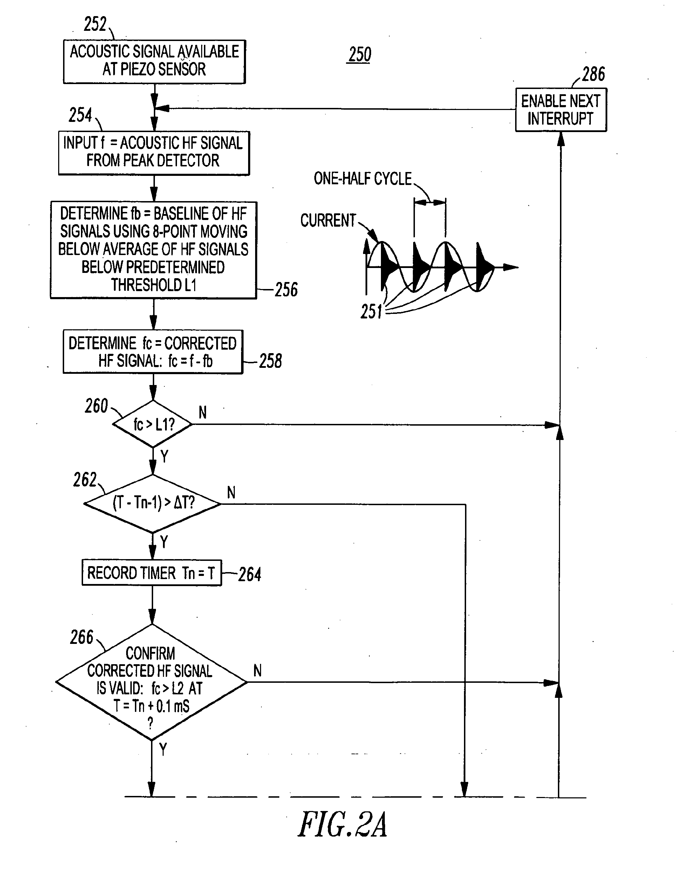

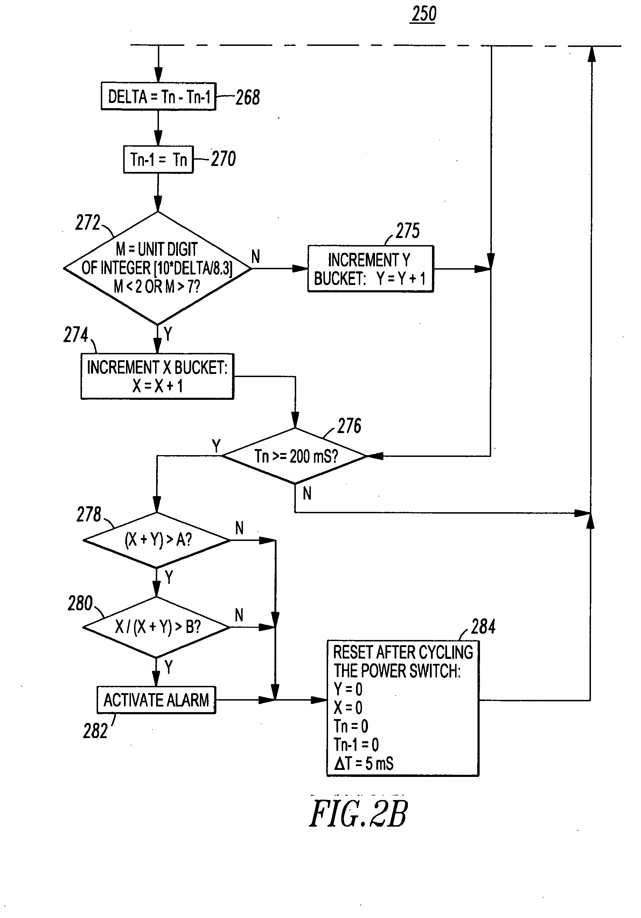

Referring to Figures 2A-2B, the routine 250 for the processor 182 of Figure 1 is shown. The general operation of this routine 250 is to obtain output from the peak detector 181 of Figure 1 and measure DELTA (step 268), the time difference between two adjacent signals from the peak detector 181. First, at 252, an acoustic signal is available at the piezoelectric element 10 and the peak acoustic signal therefrom is available at the peak detector 181. Next, at 254, the routine 250 inputs a signal, f, which is the acoustic high frequency (HF) signal from the peak detector 181.

Then, at 256, a value, fb, is determined, which is the baseline of the HF signals using, for example, an 8-point moving average of the HF signals below a predetermined threshold L1. Two L1 and L2 thresholds are employed by the routine 250 to confirm that acoustic wavelets 251 have the intended profile representative of an electrical conductivity fault. Non-limiting examples of L1 and L2 are 100 mV and 50 mV, respectively. Sometimes, the HF signal from the peak detector 181 has a relatively high noise level due to various reasons such as, for example, increased EMI noise. In order to avoid the effect of baseline noise level variation, step 256 seeks to take the noise level out of the measured signal by estimating the noise level using the example 8-point moving average on those HF signals below the predetermined threshold L1. The example 8-point moving average is the average value of the last example eight samples whose values are below the L1 threshold. Next, at 258, the corrected HF signal, fc, is determined from f - fb.

At 260, it is determined if fc is greater than L1. If so, then it is determined if T - Tn-1 is greater than ΔT (e.g., a predefined value such as 5 mS) at 262. T is the time from a suitable timer (not shown) (e.g., without limitation, an oscillator circuit (not shown) in the processor 182 of Figure 1; a crystal oscillator (not shown) in the processor 182). DELTA is reset to zero at 284 (where Tn = Tn-1 = 0) after the routine 250 reaches its predetermined time period at 276. If the test passes at 262, then at 264, the timer value, T, is recorded as Tn. Tn = T means that time T is recorded as Tn when there is an acoustic signal coming out of the peak detector 181 that is higher than the L1 threshold. Next, step 266 confirms that the corrected HF signal is valid if fc is greater than L2 at T = Tn + 0.1 mS. If so, then variable DELTA is set equal to Tn - Tn-1. Then, at 270, Tn-1 is set equal to Tn.

Next, at 272, it is determined if M is less than 2 or greater than 7, where M is the unit digit of integer [10*DELTA/8.3333]. This checks if DELTA is a multiple of 8.3333 mS (e.g., without limitation, DELTA/8.3333 = 2.1, then (DELTA/8.3333) x 10 = 21, and M = 1 which is less than 2. So DELTA in this case can be considered as a multiple of 8.3333 mS considering the potential measurement error. Effectively, step 272 determines if DELTA is a multiple of one-half line cycle (e.g., without limitation, about 8.3 mS). M represents the digit after the digit point, such as, for example, M = 2 for 3.24 or M = 8 for 5.82. If the test passes at 272 and DELTA is a multiple of one-half line cycle, then, at 274, one is added to an X bucket. On the other hand, if DELTA is not a multiple of one-half line cycle, then, at 275, one is added to a Y bucket.

After steps 274 or 275, or if the test failed at 262, then at 276, it is determined if Tn is greater than or equal to a predetermined time (e.g., without limitation, 200 mS; 2 S; 10 S; one day). If so, then at 278 and 280, the routine 250 checks two criteria before it declares that the noise is induced by an electrical conductivity fault, such as a glowing contact. Step 278 checks if X + Y >= A (e.g., without limitation, 10; 15; any suitable value); and step 280 checks if the ratio of X / (X + Y) > B (e.g., without limitation, 60%; any suitable percentage less than 100%). If these two tests pass, then an alarm (e.g., the fault indicator 158 of Figure 1) is activated at 282. Otherwise, if one or both of these two tests fail, or after 282, the routine 250 causes a reset after cycling of power (e.g., if power from the power supply 162 of Figure 1 cycles; if a manual power switch (not shown) is cycled), then values Y, X, Tn and Tn-1 are reset to zero and ΔT is set to 5 mS at 284, and the next interrupt is enabled at 286. Step 286 is also executed if any of the tests fail at 260, 266 and/or 276. Interrupts occur periodically (e.g., without limitation, every 100 µS). Also, the X and Y buckets of respective steps 274 and 275 are reset to zero after a predetermined time (e.g., without limitation, 10,000 mS; any suitable time).

The example routine 250 is similar to those of U.S. Patent No. 7,148,696. However, it adds various features such as, for example, the L2 threshold in order to confirm that the wavelet contour is correct for each acoustic signal.

### Example 3

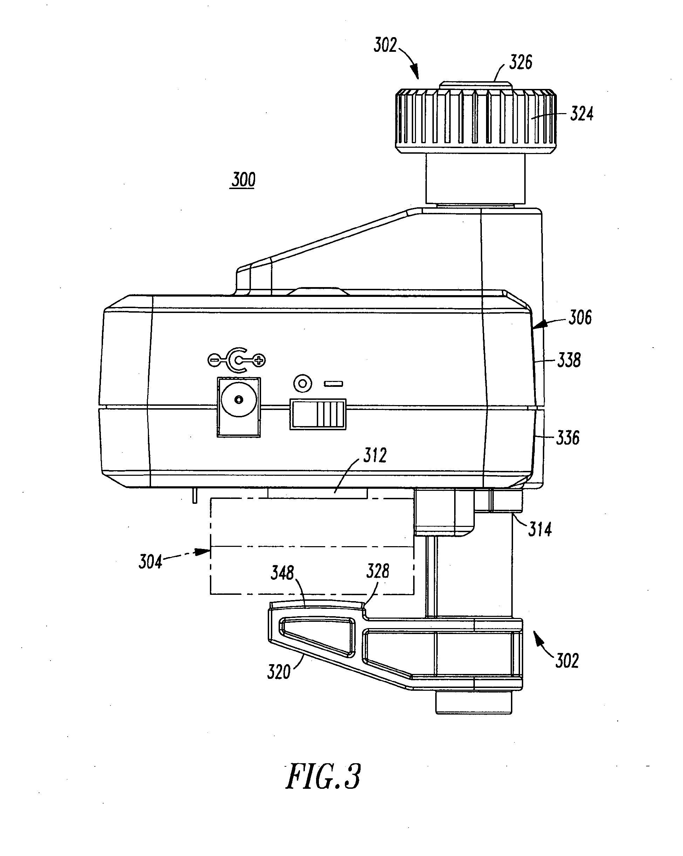

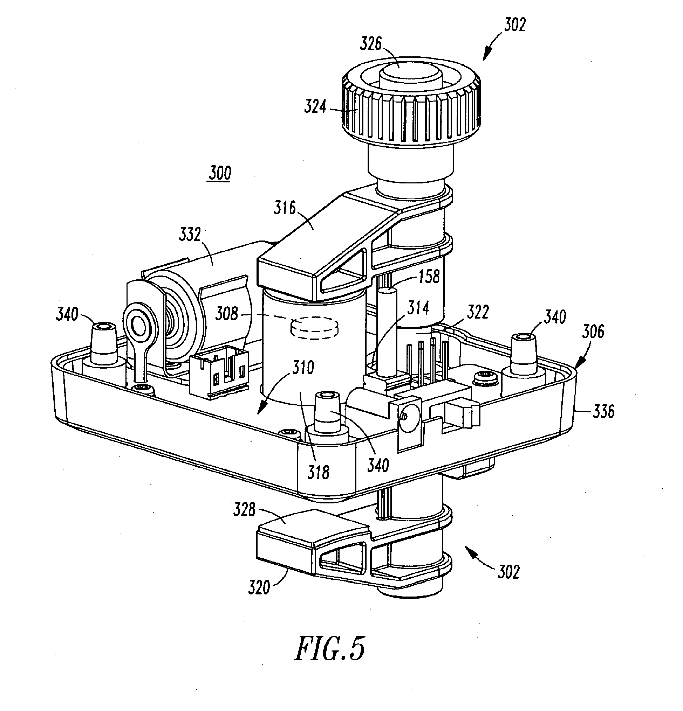

Referring to Figures 3-5, an acoustic sensor apparatus 300 includes a clamp, such as the example clamp-on structure 302, for an electrical power conductor, such as the example rectangular power bus bar 304 (shown in phantom line drawing in Figure 3). The example acoustic sensor apparatus 300 also includes a housing 306 for an acoustic sensor and/or an acoustic generator, such as a low cost piezoelectric element 308 (shown in hidden line drawing in Figure 5) housed within the housing 306, and a printed circuit board (PCB) 310 (Figure 5), which can include the example electronic circuit 14, fault indicator 158, wireless transceiver 160, parasitic power supply 162 and reset circuit 184 of Figure 1. The housing 306 is clamped onto power bus bar 304 or another power conductor in an electrical system (not shown).

### Example 4

As shown in Figure 3, the exterior of the housing 306 includes an insulation spacer 312, which is coupled to the stainless steel cylindrical canister 318 wherein piezoelectric element 308 (shown in hidden line drawing) is disposed (Figure 5). The clamp-on structure 302 is structured to clamp together the insulation spacer 312 and the example power bus bar 304 along with the housing 306.

### Example 5

The housing 306 can be, for example and without limitation, a metallic housing or an insulative housing having an internal and/or external metal coating structured to provide EMI shielding.

### Example 6

The metal coating can be, for example and without limitation, a suitable thin film metal coating.

### Example 7

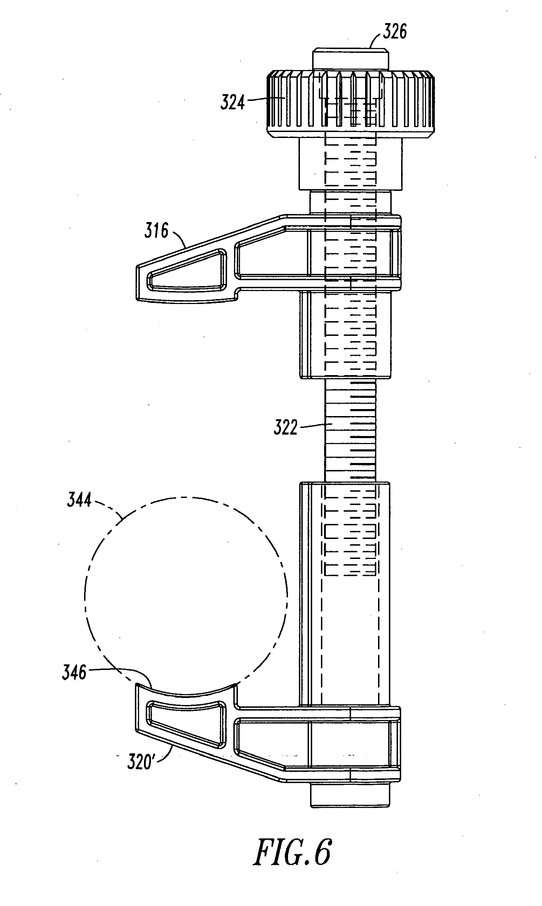

As is best shown in Figure 5, the example clamp-on structure 302 is disposed through opening 314 of the housing 306. The clamp-on structure 302 includes a first insulative clamp portion 316 disposed within the housing 306 and engaging a stainless steel cylindrical canister 318 that houses the piezoelectric element 308 (shown in hidden line drawing) therein, a second insulative clamp portion 320 disposed outside of the housing 306 and being structured to engage the power bus bar 304 (Figure 3), and a threaded coupler, such as the example threaded dowel 322, passing through the first clamp portion 316 and through the housing 306. The threaded dowel 322 has a first end and an opposite second threaded end (shown in Figure 6) threadably coupled to the second clamp portion 320 (as shown with the second clamp portion 320' in Figure 6).

A rotatable member, such as the example circular, insulative fastening knob 324, is coupled to and structured to rotate along the threaded dowel 322 in order to move up or down to pull or push the second clamp portion 320 and clamp or unclamp, respectively, the housing 306, the power bus bar 304 and the second clamp portion 320. An insulative screw cap 326 keeps the knob 324 from rotating off the first end of the threaded dowel 322.

Preferably, the second clamp portion 320 has an insulative cushion 328 structured to insulatively engage the power bus bar 304.

The piezoelectric element 308 is within the example 0.5" diameter stainless steel cylindrical canister 318 and is coupled to the bottom of the canister 318, which is opposite the side of the insulative spacer 312 (e.g., a ceramic disk) (Figure 3).

### Example 8

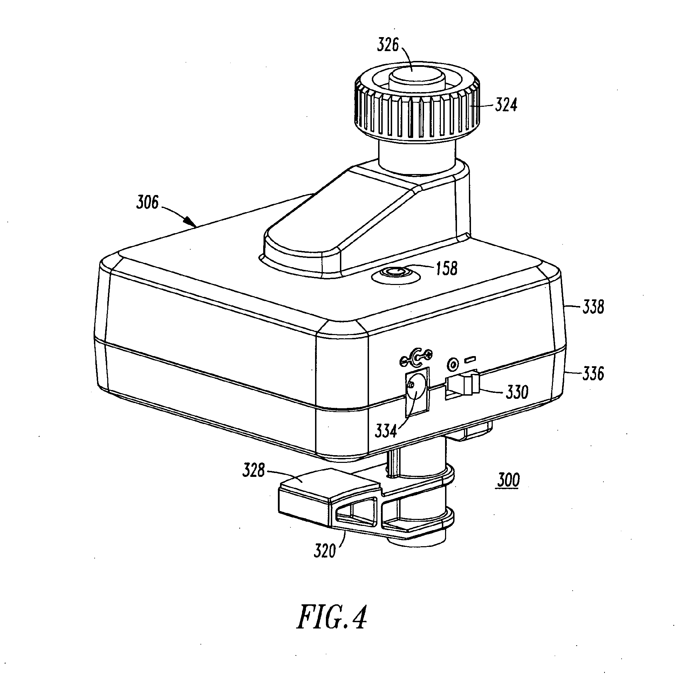

As shown in Figure 4, the example acoustic sensor apparatus 300 includes the fault indicator 158 of Figure 1, which can be an LED indicator (e.g., without limitation, green flashing for normal operation; red flashing for detection of an electrical conductivity fault operatively associated with the power bus bar 304). An on/off switch 330 can enable or disable the power supply 162 of Figure 1, which can include a battery 332 as shown in Figure 5. Also, the power supply 162 can accept DC power from an external AC/DC or DC/DC power supply (not shown) through DC power input 334.

### Example 9

As can be seen from Figures 3-5, the example housing 306 includes a base 336 and a cover 338. The base 336 includes posts 340, which engage corresponding structures (not shown) of the cover 338.

### Example 10

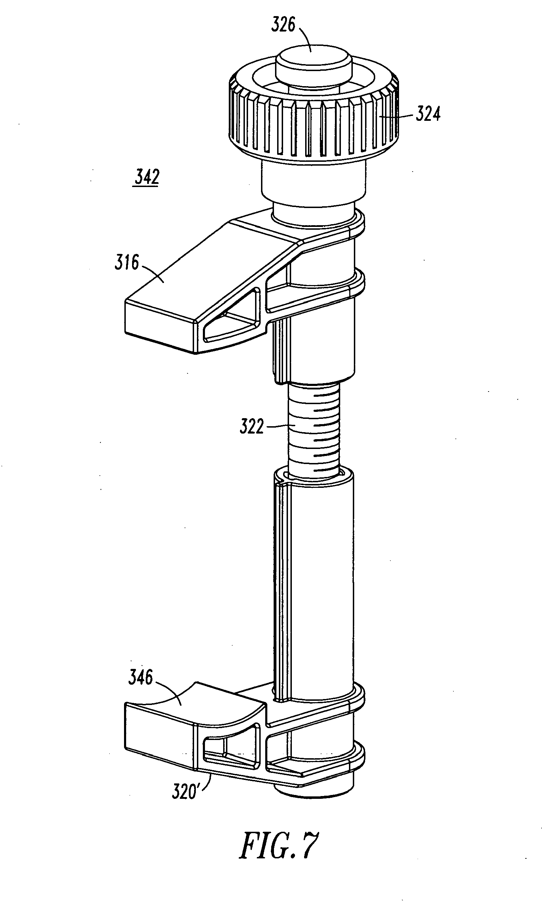

Referring to Figures 6 and 7, another clamp-on structure 342 is for a power conductor 344 (shown in phantom line drawing in Figure 6) and another acoustic sensor apparatus (not shown), which, except for the clamp-on structure 342, can be the same as or similar to the acoustic sensor apparatus 300 of Figures 3-5. The second clamp portion 320' is somewhat different than the second clamp portion 320 of Figure 3. In particular, the clamp surface 346 is a concave arcuate surface to accommodate the circular or elliptical cross section of the power conductor 344. Conversely, the second clamp portion 320 of Figure 3 has a flat, generally flat or somewhat convex surface 348 to accommodate the planar surface of the power bus bar 304. In this example, no insulative cushion is employed since electrical cables usually have insulative sleeves thereon. Otherwise, the clamp-on structure 342, like the clamp-on structure 302, can clamp together a housing, such as 306, the power conductor 344, and optionally an insulative spacer, such as 312.

The disclosed acoustic sensor apparatus 300 can sense a loose connection or other electrical conductivity fault and preferably includes a suitable acoustic generator, such as a high voltage pulsar circuit, to generate a simulated acoustic signal. This allows it to be used as an acoustic signal generator for optimizing sensor distribution in electrical distribution systems, such as switchgear, in factories or on site. The clamp-on feature allows it to move around relatively easily (e.g., not for permanent installation).

The disclosed concept can be employed in association with, for example and without limitation, three-phase switchgear, such as low voltage switchgear, low voltage switch boards, low voltage panel boards, motor control centers and medium voltage switchgear. However, it will be appreciated that the disclosed concept can be employed with a wide range of other applications, such as busway electrical systems for commercial or industrial facilities, aerospace applications, and electric vehicle applications. Also, the disclosed concept is not limited to three-phase applications and can be applied to residential or other single-phase applications. In residential applications, the acoustic signal has a relatively high attenuation rate with relatively small electrical conductors; hence, each acoustic sensor can cover only a relatively short range of the electrical wiring system. For example, each phase can employ a separate sensor. So, for instance, for a three-phase system, there are three sensors.

The example acoustic sensor apparatus 300 can act as an acoustic transmitter. When the piezoelectric element 308 experiences stress and strain, it generates a voltage output. In this case, it is employed as a sensor. When a voltage is applied across the piezoelectric element 308, the dimension of the piezoelectric element changes. This characteristic can be used as an acoustic transmitter or generator.

While specific embodiments of the disclosed concept have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of the disclosed concept which is to be given the full breadth of the claims appended and any and all equivalents thereof.

### Further Summary of the Invention:

1. An acoustic sensor apparatus comprising:
   a housing;
   a clamp structured to clamp together said housing and an electrical power conductor;
   an acoustic sensor structured to detect acoustic noise from said electrical power conductor and output a signal; and
   a circuit structured to detect an electrical conductivity fault from the signal.
2. The acoustic sensor apparatus of 1 wherein a preload is applied to the acoustic sensor by a compression element.
3. The acoustic sensor apparatus of 2 wherein the compression element is a loaded compression spring.
4. The acoustic sensor apparatus of 1 wherein said housing is a metallic housing or an insulative housing having a metal coating structured to provide EMI shielding.
5. The acoustic sensor apparatus of 4 wherein said metal coating is a thin film coating.
6. The acoustic sensor apparatus of 1 wherein said clamp is disposed through said housing.
7. The acoustic sensor apparatus of 6 wherein said electrical power conductor is a rectangular bus bar; and wherein said clamp is structured to clamp together said housing and said rectangular bus bar.
8. The acoustic sensor apparatus of 6 wherein said electrical power conductor is a power cable having a circular or elliptical cross section; and wherein said clamp is structured to clamp together said housing and said power cable.
9. The acoustic sensor apparatus of 1 wherein said circuit comprises a communication device structured to communicate with a remote device upon detection of the electrical conductivity fault.
10. The acoustic sensor apparatus of 9 wherein said communication device is a wireless transmitter or a wireless transceiver.
11. The acoustic sensor apparatus of 1 wherein said circuit is powered by a battery or a parasitic power supply.
12. The acoustic sensor apparatus of 11 wherein said parasitic power supply includes a current transformer.
13. The acoustic sensor apparatus of 1 wherein said acoustic sensor is a piezoelectric element.
14. The acoustic sensor apparatus of 1 wherein said electrical conductivity fault is a glowing contact.
15. The acoustic sensor apparatus of 1 wherein said housing includes an insulation spacer coupled to said acoustic sensor and being external to said housing; and wherein said clamp is further structured to clamp together said insulation spacer and said electrical power conductor.
16. The acoustic sensor apparatus of 1 wherein said acoustic sensor is further structured to generate an acoustic signal.
17. The acoustic sensor apparatus of 1 wherein said signal is a first signal; and wherein said circuit comprises:
   an amplifier structured to amplify the first signal and output a second signal;
   a peak detector structured to input the second signal and output a third signal; and
   a processor structured to process the third signal and detect the electrical conductivity fault therefrom.
18. The acoustic sensor apparatus of 1 wherein said acoustic sensor is housed within said housing.
19. The acoustic sensor apparatus of 1 wherein said clamp comprises:
   a first clamp portion disposed within said housing and engaging said acoustic sensor,
   a second clamp portion disposed outside of said housing and being structured to engage said electrical power conductor,
   a threaded coupler passing through said first clamp portion and through said housing, said threaded coupler having a first end and an opposite second threaded end threadably coupled to said second clamp portion, and
   a rotatable member coupled to and structured to rotate along the first end of said threaded coupler in order to move up or down to pull or push said second clamp portion and clamp or unclamp, respectively, said housing, said electrical power conductor and said second clamp portion.
20. The acoustic sensor apparatus of 19 wherein said second clamp portion has an insulative cushion structured to insulatively engage said electrical power conductor.
21. The acoustic sensor apparatus of 19 wherein said rotatable member is a circular fastening knob threaded to said threaded coupler.
22. An acoustic apparatus for an electrical power conductor, said acoustic apparatus comprising:
   a housing;
   a clamp structured to clamp together said housing and said electrical power conductor; and
   at least one of:
      (a) an acoustic sensor structured to detect acoustic noise from said electrical power conductor and output a signal, and a circuit structured to detect an electrical conductivity fault from the signal, and
      (b) an acoustic transmitter structured to generate acoustic noise to mimic acoustic noise induced by an electrical conductivity fault.

### REFERENCE NUMERICAL LIST

- 2: acoustic sensor assembly
- 4: housing, such as a sensor housing and mounting structure
- 6: clamp
- 8: electrical power conductor
- 10: piezoelectric element
- 12: output signal
- 14: electronic circuit
- 16: electrical conductivity fault signal
- 154: optional preload
- 158: fault indicator
- 160: communication device, such as a wireless transceiver
- 162: power supply
- 164: coupling
- 168: insulation spacer
- 174: buffer input circuit
- 178: amplifier circuit
- 180: bandpass filter
- 181: peak detector
- 182: processor
- 184: reset circuit
- 200: routine
- 202: step
- 204: step
- 206: step
- 208: step
- 210: step
- 212: step
- 214: step
- 216: step
- 218: step
- 220: step
- 222: step
- 224: step
- 250: routine
- 252: step
- 254: step
- 256: step
- 258: step
- 260: step
- 262: step
- 264: step
- 266: step
- 268: step
- 270: step
- 272: step
- 274: step
- 276: step
- 278: step
- 280: step
- 282: step
- 284: step
- 286: step
- 288: step
- 300: acoustic sensor apparatus
- 302: clamp, such as the example clamp-on structure
- 304: electrical power conductor, such as the example rectangular power bus bar
- 306: housing
- 308: acoustic sensor and/or an acoustic generator, such as a low cost piezoelectric element
- 310: printed circuit board (PCB)
- 312: insulation spacer
- 314: opening
- 316: first clamp portion
- 318: stainless steel cylindrical canister
- 320: second clamp portion
- 320': second clamp portion
- 322: threaded dowel
- 324: circular, insulative fastening knob
- 326: insulative screw cap
- 328: insulative cushion
- 330: on/off switch
- 332: battery
- 334: DC power input
- 336: base
- 338: cover
- 340: posts
- 342: clamp-on structure
- 344: power conductor
- 346: clamp surface
- 348: surface

## Claims

1. An acoustic sensor apparatus (300) comprising:
a housing (306);
a clamp (302;342) structured to clamp together said housing (306) and an electrical power conductor (304;344);
an acoustic sensor (10;308) structured to detect acoustic noise from said electrical power conductor and output a signal (12); and
a circuit (14) structured to detect an electrical conductivity fault (16) from the signal.

2. The acoustic sensor apparatus (300) of Claim 1 wherein a preload (154) is applied to the acoustic sensor by a compression element,
wherein the compression element may preferably be a loaded compression spring.

3. The acoustic sensor apparatus (300) of Claim 1 or 2, wherein said housing (306) is a metallic housing or an insulative housing having a metal coating structured to provide EMI shielding,
wherein said metal coating may preferably be a thin film coating.

4. The acoustic sensor apparatus (300) of Claim 1 wherein said clamp (302;342) is disposed through said housing (306),
wherein said electrical power conductor may preferably be a rectangular bus bar (304); and wherein said clamp (302) may preferably be structured to clamp together said housing (306) and said rectangular bus bar (304), and/or
wherein said electrical power conductor may preferably be a power cable (344) having a circular or elliptical cross section; and wherein said clamp (342) is structured to clamp together said housing (306) and said power cable (344).

5. The acoustic sensor apparatus (300) of any one of the preceding Claims wherein said circuit (14) comprises a communication device (160) structured to communicate with a remote device upon detection of the electrical conductivity fault,
wherein said communication device may preferably be a wireless transmitter or a wireless transceiver (160).

6. The acoustic sensor apparatus (300) of any one of the preceding Claims 1 wherein said circuit (14) is powered by a battery (332) or a parasitic power supply (162), wherein said parasitic power supply (162) may preferably includes a current transformer.

7. The acoustic sensor apparatus (300) of Claim 1 wherein said acoustic sensor is a piezoelectric element (10), and/or
wherein said acoustic sensor (308) may preferably be further structured to generate an acoustic signal.

8. The acoustic sensor apparatus (300) of any one of the preceding Claims, wherein said electrical conductivity fault is a glowing contact.

9. The acoustic sensor apparatus (300) of any one of the preceding Claims wherein said housing (306) includes an insulation spacer (168) coupled to said acoustic sensor and being external to said housing (306); and wherein said clamp (302) is further structured to clamp together said insulation spacer and said electrical power conductor.

10. The acoustic sensor apparatus (300) of any one of the preceding Claims, wherein said signal is a first signal (12); and wherein said circuit comprises:
an amplifier (178) structured to amplify the first signal and output a second signal;
a peak detector (181) structured to input the second signal and output a third signal; and
a processor (182) structured to process the third signal and detect the electrical conductivity fault therefrom.

11. The acoustic sensor apparatus (300) of any one of the preceding Claims wherein said acoustic sensor is housed within said housing (306).

12. The acoustic sensor apparatus (300) of any one of the preceding Claims wherein said clamp (302) comprises:
a first clamp portion (316) disposed within said housing (306) and engaging said acoustic sensor (318,308),
a second clamp portion (320;320') disposed outside of said housing (306) and being structured to engage said electrical power conductor (304;344),
a threaded coupler (322) passing through said first clamp portion and through said housing (306), said threaded coupler having a first end and an opposite second threaded end threadably coupled to said second clamp portion, and
a rotatable member (324) coupled to and structured to rotate along the first end of said threaded coupler in order to move up or down to pull or push said second clamp portion and clamp or unclamp, respectively, said housing (306), said electrical power conductor (304;344) and said second clamp portion (320;320').

13. The acoustic sensor apparatus (300) of Claim 12 wherein said second clamp portion has an insulative cushion (328) structured to insulatively engage said electrical power conductor (304).

14. The acoustic sensor apparatus (300) of Claim 12 or 13, wherein said rotatable member is a circular fastening knob (324) threaded to said threaded coupler.

15. An acoustic apparatus (300) for an electrical power conductor (304;344), said acoustic apparatus (300) comprising:
a housing (306);
a clamp (302;342) structured to clamp together said housing (306) and said electrical power conductor (304;344); and
at least one of:
(a) an acoustic sensor (10;308) structured to detect acoustic noise from said electrical power conductor and output a signal, and a circuit (14) structured to detect an electrical conductivity fault from the signal, and
(b) an acoustic transmitter (308) structured to generate acoustic noise to mimic acoustic noise induced by an electrical conductivity fault.
